# EUROPEAN PATENT APPLICATION

(11) **EP 2 869 679 A1**
(43) Date of publication of application: **06.05.2015**
(21) Application number: 13191473.1
(22) Date of filing: 04.11.2013
(51) Int. Cl.: H05K 7/14, H04L 12/931, G06F 11/20

(54) **Power supply system**

(71) Applicant: Alcatel Lucent, 75007 Paris (FR)
(72) Inventor: Goetz, Hans-Joachim, 90411 Nürnberg (DE); Haberditzl, Rainer, 90411 Nürnberg (DE); Seitz, Reinhold, 90411 Nürnberg (DE)
(74) Representative: Wetzel, Emmanuelle

(57) **Abstract**

A power supply arrangement comprises:
a plurality of power supply areas;
a plurality of subsystem interfaces to connect subsystems, each subsystem interface coupled with one power supply area to supply power to the at least one subsystem connected with the subsystem interface; and
a power supply interface coupled with the plurality of power supply areas and
comprising a plurality of power supply terminals for being connected with one or more power supply lines, and configurable power distribution means for connecting the power supply terminals with the power supply areas,
wherein the number of power supply terminals is smaller than the number of power supply areas and the maximum powers that can be drawn by the subsystems connected to the individual power supply areas are arranged such that the load for each connected power supply line is about the same, for all configurations of the power distribution means.

## Description

### Background

This document relates to a power supply arrangement and to a method for power distribution in electronic equipment, wherein the supplied power levels can be adjusted flexibly when the power needs of the electronic equipment change.

Power supply systems of known devices, such as e.g. subrack devices of a telecommunication network, are often designed according to the maximum load that may occur if the device is equipped with the maximum number of electronic subsystems. However, when a device is first installed, the power requirements of the device may be relatively low as it may be equipped with a smaller number of electronic subsystems in order to allow for future expansion. In this case, the power supply system would be oversized for the actual power requirements of the device.

There is thus a need to provide a power supply arrangement, wherein the power supply can be adapted to the changing power requirements of the powered electronic equipment.

### Summary

According to an aspect, a power supply arrangement is provided, having a plurality of power supply areas and a plurality of subsystem interfaces to connect subsystems, each subsystem interface coupled with one power supply area to supply power to the at least one subsystem connected with the subsystem interface. Therein, each power supply area may be coupled with a plurality of subsystem interfaces, wherein the number of subsystem interfaces need not be identical for different power supply areas. The power supply areas may be provided on a printed circuit board, e.g. on a backplane of an electronic device. Alternatively, cable distribution systems or busbars may be provided instead of the backplane. Further, a power supply interface is coupled with the plurality of power supply areas and comprises a plurality of power supply terminals for being connected with one or more power supply lines. The power supply lines may be copper cables for connecting the power supply arrangement to a power supply, such as e.g. a battery. The power supply arrangement further comprises configurable power distribution means for connecting the power supply terminals with the power supply areas. Therein, the number of power supply terminals is smaller than the number of power supply areas. Thus, the number of power supply lines may be reduced compared to an arrangement, wherein power supply lines are connected directly to power supply areas. Further, the maximum powers that can be drawn by the subsystems connected to the individual power supply areas are arranged such that the maximum combined load for each connected power supply line is about the same, for all configurations of the power distribution means. Thus, the power supply arrangement provides a balanced power supply and prevents an excessive maximum load being drawn by one power supply line while other power supply lines carry only little maximum load. A flexible power supply is provided for the subsystems, as the configurable power distribution means can be re-configured if the power requirements of the subsystems change and/or if the number of subsystems connected to the power supply areas changes. There is no need to change the power supply areas or to rearrange individual subsystems, as any adaptation of the power supply arrangement to changed power requirements can be performed by a suitable reconfiguration of the power distribution means of the power supply interface.

Thus, for a device with low power requirements, the power distribution means may be configured such that a single power supply line may provide power to all of the device's subsystems. As the device is expanded and its power dissipation increases, the power distribution means may be re-configured such that the power supplied to the device's subsystems is carried, in a balanced manner as described above, by two, three or more power supply lines, wherein additional power supplies may be utilized in order to provide sufficient power to the device.

According to embodiments, at least one power distribution configuration of the power distribution means may connect at least two power supply areas with one power supply terminal. Thus, for a device with low power requirements, a common power supply line may provide power to the subsystems connected to at least two power supply areas, thus providing an adequate amount of power to the subsystems while avoiding the use of an extensive number of expensive copper cables in the power supply arrangement.

According to embodiments, all power distribution configurations of the power distribution means may connect at least two power supply areas with one power supply terminal. Thus, the power distribution means may e.g. always connect power supply areas such that power supply areas with a smaller maximum power requirement are connected to form a combined power supply area which has a maximum power requirement that is substantially identical to the maximum power requirement of another power supply area. Thus, the maximum load drawn by each power supply line may be balanced, even though more than one power supply area may be connected to a single power supply terminal.

According to embodiments, the power distribution means may comprise a bridge for connecting at least one power supply terminal, and thus also for connecting at least one power supply area. Such a bridge allows to easily connect and disconnect power supply terminals in order to reconfigure the power distribution means and adapt it to changed power requirements.

According to embodiments, the power supply terminals may be spaced at regular distances and the bridge may comprise at least one bridging element to connect neighboring power supply terminals. With the power supply terminals spaced at regular distances, a bridging element may e.g. be used for connecting two neighboring power supply terminals on the power supply interface, such that a single bridging element may be used in a variety of different configurations of the power distribution means.

According to embodiments, the power supply terminals may be disposed in a two-dimensional grid where neighboring power supply terminals are displaced in both dimensions. This arrangement allows to efficiently use the available space of the power interface for spacing the power supply terminals and their associated conductive paths across the available space of the power interface. Therein, the respective spacing between adjacent power supply terminals in a given direction may be constant, allowing for a single bridging element to be used for connecting any two adjacent power supply terminals for a specific configuration of the power distribution means. Alternatively, if e.g. cables are used for bridging, the power supply terminals may be disposed in any arrangement that facilitates the creation and adaptation of bridging configurations, wherein two or more power supply terminals may be connected by a bridging element and wherein a bridging element may be disconnected from one pair of power supply terminals and re-connected to a different pair of power supply terminals.

According to embodiments, the bridge may comprise at least two substantially identical bridging elements. With the regularly spaced power supply terminals, as outlined above, a number of substantially identical bridging elements may be used for connecting a number of neighboring power supply terminals in order to build a configuration of the power distribution means. Therein, the bridging elements may have substantially identical form and dimensions or a substantially identical shape. Thus, using only one type of bridging element, all configurations of the power distribution means may be formed. Alternatively, a set which comprises bridging elements of a range of sizes and dimensions, e.g. different lengths of bridging cable, may be provided. In this case, a bridging configuration may be created from appropriately sized and arranged bridging elements from the set.

For some embodiments of the power supply arrangement, a variety of supply voltages and a ground contact may be provided by the power supply arrangement for powering the subsystem components. In this case, each power supply area may be connected to a variety of supply voltages via its associated power supply terminal. The bridge element may be adapted to provide separate conductor pathways for connecting the different supply voltages to respective connectors of the power supply terminals and thus also to respective connectors of the power supply areas. According to some embodiments, a bridging element may comprise several separate bridging portions for separately connecting each different supply voltage path (i.e. each power supply voltage and ground).

According to embodiments, the numbers of subsystem interfaces connected to each power supply area may be selected so that the maximum combined load for each power supply line drawn by the subsystems connectable to the power supply line via the power distribution means and the subsystem interfaces is about the same, for all configurations of the power distribution means. Thus, the maximum load is balanced over the power supply lines, even if the number of power supply lines may change for the different configurations.

According to embodiments, the backplane may have a plurality of conductive power supply planes that correspond to the plurality of power supply areas. The surface areas of the individual power supply planes may have a predetermined ratio that depends on the number of power supply terminals. For example, the surface areas of the power supply planes may be a fraction of the total available area for power supply on the backplane where the denominator corresponds to the number of power supply terminals, or a multiple thereof. For instance, in a case with 3 power supply terminals, the surface areas of the power supply planes may be a multiple of 1/3, 1/6, 1/9, etc. Therein, the planes may e.g. correspond to conductor planes which are arranged on the backplane such that each conductor plane defines a power supply area which supplies power from an associated power supply terminal to any subsystems located within the power supply area. Further, the surface areas of the power supply plane may be correlated with the maximum power draw of the subsystem interfaces connected by the power supply plane, such that different power supply planes which have the same area also have substantially the same maximum power draw.

According to embodiments, the subsystem interfaces may comprise a number of interface slots to receive printed circuit boards, the subsystems arranged on the printed circuit boards. The interface slots may provide data connection and power supply functions to the subsystems.

According to embodiments, the power supply areas may each support a predetermined portion of the total maximum power supplied by the power supply arrangement. The maximum power supported by at least two power supply areas may be half the maximum power supported by at least two other power supply areas. Thus, some power supply areas may support a maximum power corresponding to one (arbitrary) power unit, whereas some other power supply areas may support a maximum power corresponding to one half power unit. With such an arrangement, power supply areas of varying maximum power levels may be created by suitable connections within the power supply interface. In general, the maximum power carried by some power supply areas may be a fraction (e.g. 1/2, 1/3, 1/4, etc.) of the power unit.

According to embodiments, at least one configuration of the power distribution means may connect two of the at least two power supply areas having half maximum power with a first common power supply terminal. Thus, the two connected power supply areas form a combined power supply area having a full power unit. Thus, power supply terminals of a given maximum power level, e.g. a power unit, may be formed. At least one configuration of the power distribution means may connect at least one power supply area having half maximum power and one power supply area having more than half maximum power with a second common power supply terminal. Thus, a power supply terminal with a maximum power that is larger than the maximum power draw of any one power supply area may be connected, e.g. a maximum power draw corresponding to 1½ power units. In case that the overall power requirements of the subsystems within the respective power supply areas are fairly low, a power supply interface with fewer power supply terminals with larger maximum power draws, as expressed in power units, may be configured. If the overall power requirements of the subsystems increases, a power supply interface with more power supply terminals with smaller maximum power draws, as expressed in power units, may be configured.

Therein, the predetermined portions of the total maximum power supported by the power supply areas may be 1/3, 1/6, 1/6, and 1/3. This allocation allows to configure the power distribution means such that three, two or one power supply terminal(s) may be connected to the backplane in respective configurations. For each of these configurations, all power supply terminals are connected to respective power supply areas of the same size and the maximum power draw for each power supply terminal may be constant within each configuration.

According to a further aspect, telecommunications equipment comprising a power supply arrangement as described above is provided. Such telecommunications equipment may e.g. comprise central office telecommunications equipment, and/or may comprise transmit/receive units, power supply filters, optical cross-connect systems, multiplexers, service routers and switches in datacenters or any other power distribution arrangement independent from telecommunication equipment.

According to yet a further aspect, a method for power distribution in electronic equipment is provided, wherein the equipment comprises a plurality of power supply areas; a plurality of subsystem interfaces for connecting subsystems, each subsystem interface coupled with one power supply area to supply power to the at least one subsystem when connected with the subsystem interface; and a power supply interface coupled with the plurality of power supply areas. The power supply areas may be provided on a printed circuit board, e.g. on a backplane of an electronic device. Alternatively, cable distribution systems or busbars may be provided instead of the backplane. The power supply interface may comprise a plurality of power supply terminals for being connected with one or more power supply lines, and configurable power distribution means for connecting the power supply terminals with the power supply areas. The method comprises selecting the numbers of subsystem interfaces connected to each power supply area such that the maximum powers that can be drawn by the subsystems from the individual power supply areas are limited so that the resulting maximum combined load for each power supply line is about the same, for all configurations of the power distribution means. Thus, the maximum power requirements can be balanced over the power supply lines, and the number of power supply lines can be configured, using the power distribution means, according to the overall power requirements of the electronic equipment.

### Detailed description

Various aspects are explained below in an exemplary manner with reference to the accompanying drawings, wherein:
Fig. 1 shows a schematic drawing of a device according to an embodiment;
Fig. 2 shows an example of power supply areas and different bridging options;
Fig. 3 shows an example of a power supply interface with a bridging element;
Fig. 4 shows a different bridging option for the power supply interface as shown in Fig. 3; and
Fig. 5 shows a further bridging option for the power supply interface as shown in Fig. 3.

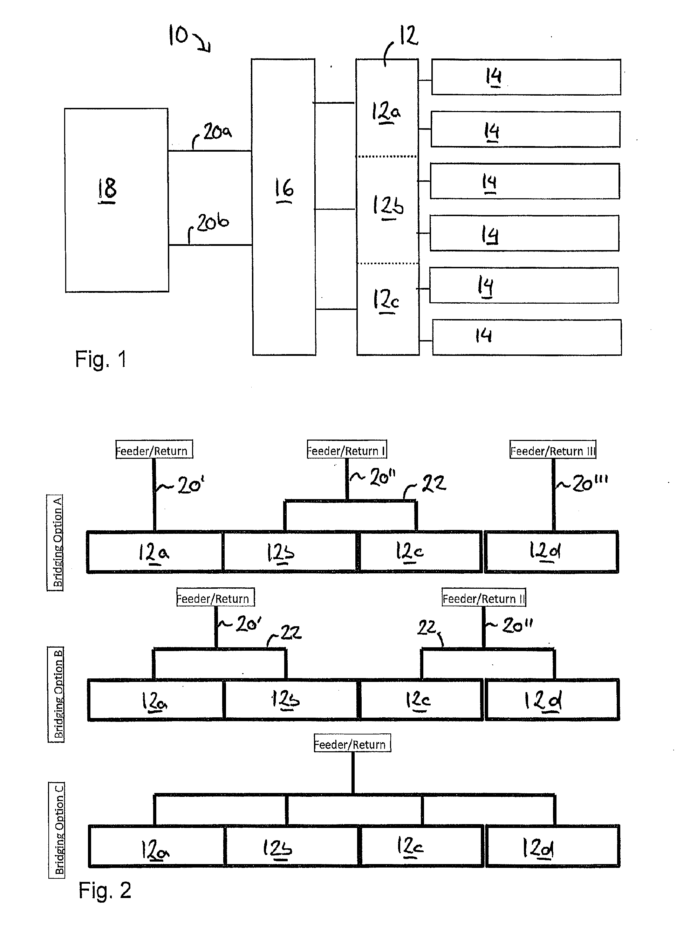

As shown in Fig. 1, a device 10, which may e.g. be a subrack in a telecommunication network equipment deployed in a telecommunication network infrastructure, comprises a backplane 12, which may be divided into a number of different backplane power supply areas 12a, 12b, 12c. The backplane 12 is provided with interfaces, e.g. slots, for accommodating subsystems or electronic components of the device, which may perform a variety of functions within the device 10. In embodiments, each slot can receive one mating printed circuit board 14 carrying one or more subsystems or electronic components.

The backplane 12 may connect, via the slots, respective pins of a plurality of printed circuit boards 14 to an interconnecting bus, and provide power supply to each subsystem. Typically, some pins and corresponding contact members of the slots carry information or control signals, while other pins/contact members carry the (at least one) supply voltage and ground. It should be noted that in embodiments the backplane interface may comprise the pins and the printed circuit boards may comprise the mating contact members. Therein, the backplane 12 does not need to be located at a "back" side of the device 10, with subsystems connected only to one side of the backplane 12, but it may also be a center plane, with subsystems connected to both sides of the backplane 12, so that the backplane 12 is located somewhere closer to the middle of the device 10. Further, instead of a backplane 12, an alternative power distribution system, such as e.g. a busbar or a cable distribution system may be used.

Each power supply area 12a, 12b, 12c of the backplane 12 provides power to a number of subsystem interfaces or slots. For example, a predetermined number of slots, each having respective power supply pins/contacts, is provided for each power supply area 12a, 12b, 12c. The number of slots in the power supply areas 12a, 12b, 12c does not need to be identical for all power supply areas 12a, 12b, 12c as will be explained below. In fact, the number of slots in the power supply areas 12a, 12b, 12c follows a given schema suggested by the inventors. As will be explained in detail below, the backplane 12 may be divided e.g. into 3, 4 or more power supply areas, wherein each area may e.g. comprise one or more conductive plates or bars, connecting individual subsystem power supplies. The conductive plates or bars may be located at a power interface of the backplane system. Typically, at least 2 copper plates or bars are provided for each power supply area; one for providing a ground connection and another for providing a supply voltage. In many cases, a plurality of different supply voltages are used to power the subsystems and a respective number of copper plates or bars are provided at the backplane to supply the individual supply voltages to respective contact members in the slots. The at least one supply voltage and ground are connected to corresponding pins of the printed circuit boards 14 which in turn comprise conductors to distribute power to the electronic components disposed on the printed circuit boards.

A power supply interface 16 is provided, which connects power supply lines 20 of a power supply 18 to the power supply areas 12a, 12b, 12c of the backplane 12. The power supply 18 may e.g. comprise a power converter or a battery for supplying DC current to the subsystems, via the backplane 12. The power supply lines 20a, 20b (e.g. one line 20a for the supply voltage the other line 20b for ground) may e.g. be copper cables with a sufficient cross-section (depending on current rating), such as e.g. a cross section in the range of 35-50mm², as the battery voltage may e.g. be in the range of 48-60V and the overall power dissipation of the device 10 may be fairly high. In case of multiple supply voltages, more than two power supply lines 20a, 20b, 20c, etc. may be provided. Reference numeral 20 is supposed to denote a complete set of power supply lines 20a, 20b, 20c, etc for all necessary supply voltages. In addition, the device 10 may be connected, via the power supply interface 16, to multiple sets of power supply lines 20', 20", 20"', etc, each set of power supply lines providing supply voltage(s) and ground to one or more power supply areas 12a, 12b, 12c of the backplane 12. In embodiments, only power supply line(s) for the supply voltage(s) are implemented separately while the ground line may be shared amongst the sets of power supply lines. Universal grounding terminals may be provided, wherein grounding cables can be terminated at any grounding terminal point.

According to embodiments, the power supply interface 16 may be configurable such that, with different configurations of the power supply interface 16, the number of power supply line sets 20', 20", 20"', etc which are connected between the one or more power supplies 18 and the power supply interface 16 may be adapted to the device's power requirements. According to some embodiments, multiple power supplies 18 may be provided. Therein, within a single configuration of the power supply interface 16, the maximum power draw for each power supply line set 20', 20", 20"', etc or the maximum power drawn for each power supply line set 20', 20", 20"', etc may be substantially equal. Within the power supply interface, a configuration may comprise connecting at least two power supply areas 12a, 12b, 12c to a single power supply line 20. This may e.g. be achieved by bridging selected power supply areas 12a, 12b, 12c in the power supply interface 16.

Fig. 2 shows different options of connecting power supply lines 20 to backplane areas 12a-d. In the example shown in Fig. 2, the backplane 12 is partitioned into four areas, wherein areas 12a and 12d each cover 1/3 of the backplane, and areas 12b and 12c each cover 1/6 of the backplane. Thus, a power unit corresponds to 1/3 of the total maximum power supplied by the power supply arrangement. Power supply areas 12a and 12d each provide for a maximum power of one power unit, and areas 12b and 12c each allow a power draw of ½ power unit.

The power supply areas may be implemented by conductor planes which physically cover and connect the respective pins of the slots for receiving the subsystem components 14 which are to be associated with a given backplane area 12. Thus, with a regular arrangement of slots for receiving printed circuit boards 14 on the surface of the backplane, a geometric arrangement of conductor planes, such as e.g. copper plates, which cover predetermined fractions of the backplane surface, may also serve to associate predetermined numbers of slots and predetermined maximum power draws with each backplane area.

In the bridging option A shown in the top part of Fig. 2, a single bridging element 22 may be used within the power supply interface to bridge areas 12b and 12c in order to create three power supply sections which each cover 1/3 of the backplane 12, and/or which may each supply power to 1/3 of the slots for powering printed circuit boards 14 carrying electronic components of the device 10. Three power supply line sets 20', 20", 20'" may be connected to the power supply sections via the power supply interface.

In the bridging option B shown in the middle part of Fig. 2, two bridging elements 22 are used to bridge areas 12a and 12b and to bridge areas 12c and 12d, thus creating two power supply sections which each cover 1/2 of the backplane 12. Two power supply line sets 20', 20" may be connected to the power supply sections via the power supply interface.

In the bridging option C shown in the bottom part of Fig. 2, three bridging elements 22 are used to bridge areas 12a, 12b, 12c and 12d, thus creating a single power supply section which covers the whole of the backplane 12. A single power supply line set 20 may be connected to the power supply section via the power supply interface. As already mentioned, a power supply line set 20a, 20b may e.g. comprise a supply voltage and ground, or it may comprise several different supply voltages with or without a separate ground potential.

Thus, using the different bridging options as shown in Fig. 2, one, two or three power supply lines 20 may be used for supplying power to the backplane 12. For a device 10 with low power requirements, the power may be supplied by a single power supply line set as shown in bridging option C, saving on costly copper cabling. As the device 10 is upgraded and additional printed circuit boards 14 are installed, the power requirements of the device may increase. Then, without any change to the backplane 12, the power supply interface 16 may be adapted to the change in power requirements by changing the bridging configuration, so that the device 10 can be supplied by two or three power supply lines as shown in the middle or the top part of Fig. 2. With the partitioning shown in Fig. 2, it can be ensured that, even with multiple power supply lines 20, the maximum power load of the power supply lines 20 remains balanced. However, the actual power dissipation during the operation of the device 10 may vary between the different power supply lines 20, as printed circuit boards 14 connected to different backplane areas 12a-d may have different individual power dissipations, as e.g. some printed circuit boards 14 may carry subsystems which draw different power levels and/or which have different activity patterns.

It must be mentioned that the printed circuit boards 14 connected to the subsystem interfaces (via slots) may not be identical and different types of printed circuit boards 14 may be employed in the system. Consequently, the maximum power drawn by the connected printed circuit boards 14 may be different. In that respect, it is noted that any printed circuit board 14 may be used as long as its maximum dissipated power is below the maximum power requirement for the corresponding subsystem interface. The above power requirements for the power supply areas are typically determined based on the maximum power requirements for the corresponding subsystem interfaces that are connected with the respective power supply area. In a similar manner, it is not necessary that all subsystem interfaces have identical maximum power limitations, and different subsystem interfaces providing different levels of maximum power to matching printed circuit boards may be used. In embodiments, it is only necessary that the total maximum power that can be drawn by the associated subsystem interfaces from the power supply areas meets the above conditions.

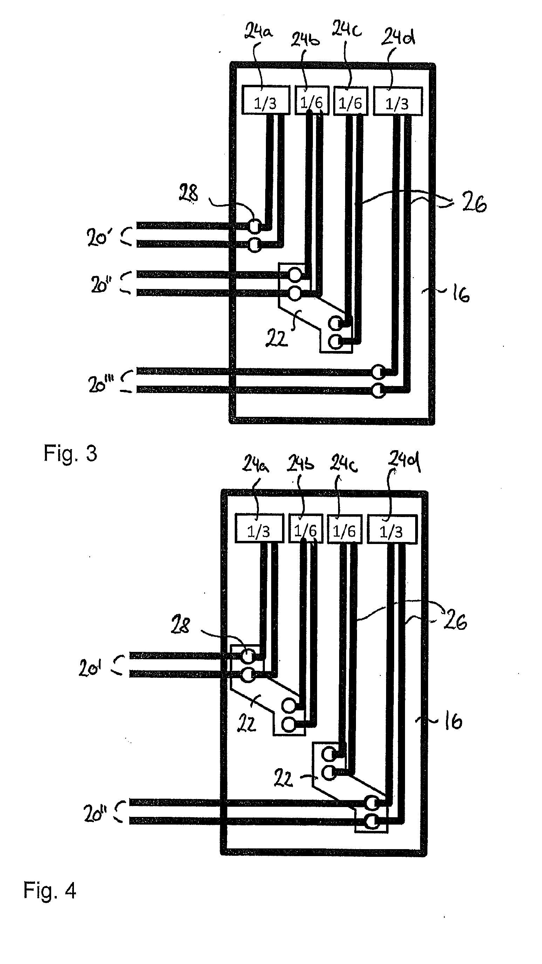

Fig. 3 to 5 provide a schematic view of the power supply interface 16 for the different bridging options as shown in Fig. 2. In the power supply interface 16 shown in Fig. 3, connectors 24a-d are provided which connect to power supply planes on the backplane 12. The power supply planes may be formed on the backplane 12 by respective conductor planes, such as copper sheets, which cover a respective fractional area of the backplane surface, thus connecting the slots provided within the respective fractional area. Hence, relative sizes and respective maximum loads of power supply areas may be adjusted by changing the relative sizes and arrangements of associated power supply planes. On the power supply interface 16, each connector 24a-d is associated with a respective power supply plane, wherein, in Fig. 3-5, the fractional size of the associated power supply plane is noted on the connector 24a-d.

Various conductive paths 26 may be used within the power supply interface 16 to connect the backplane power plane connectors 24a-d to power supply terminals 28. The power supply terminals 28 may be arranged in a regular pattern on the surface of the power supply interface 16, such that the distance between consecutive pairs of power supply terminals 28 is constant. The power supply terminals may e.g. comprise nuts and washers or the like, which are connectable to cable lugs of power supply lines 20. In case of a DC power supply, such as a battery, two power supply lines 20a, b may be provided for connecting both battery terminals to the backplane 12 via the power supply interface 16.

In the example shown in Fig. 3, a bridging element 22 is provided for connecting the power supply terminals 28 that in turn are connected via connectors 24b and 24c to the respective backplane power planes which each cover 1/6 of the backplane surface area (see bridging option A in the top part of Fig. 2). The bridging element 22 may e.g. be a punched metal plate which may be slipped onto the power supply terminals 28 and which may be held in place by the same nut that is used for connecting the respective power supply line 20.

For ease of illustration, only a simple bridging element 22 is schematically shown in Fig. 3. However, it is to be understood that, for a supply line set 20 comprising e.g. different supply voltages and possibly also a ground connection, a complex bridging element 22 may be used, wherein a separate bridging connection is provided for each individual supply voltage and ground. Such a complex bridging element may e.g. comprise a plurality of simple bridging elements arranged side by side, wherein each simple bridging element provides a connection for a given supply voltage or ground. Alternatively, a complex bridging element may comprise a plurality of conductor paths arranged within, e.g. stacked on a printed circuit board, such that each conductor path provides a connection for a given supply voltage or ground.

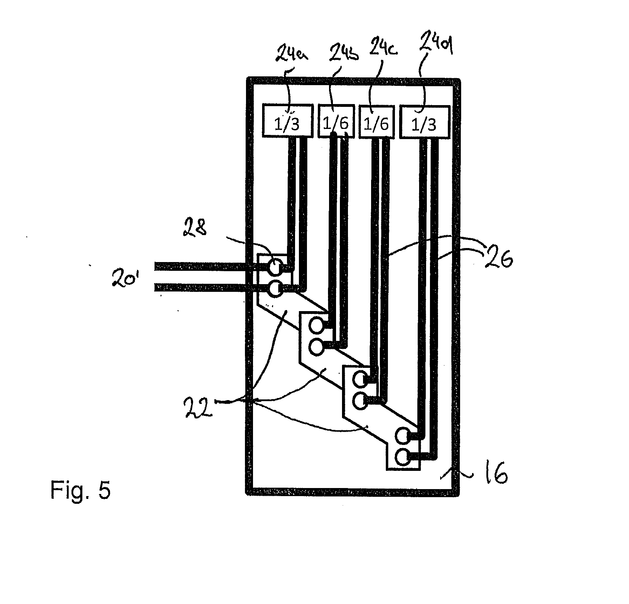

As shown in Fig. 4 and 5, due to the regular arrangement of the power supply terminals 28 on the power supply interface 16, a set of identical bridging elements 22 may be used for generating each of the bridging options A-C as shown in Fig. 2, i.e. a bridging element 22 may connect any two neighboring power supply terminals 28. If the power supply terminals 28 comprise nuts and washers, the removal and installation of bridging elements 22 can be performed quickly and easily, so that the power supply interface 16 can be easily adjusted to changed power requirements of the device.

In the example embodiment shown in Fig. 3-5, the backplane is partitioned into four areas, covering 1/3, 1/6, 1/6 and 1/3 of the backplane, respectively. This partitioning allows to connect 1, 2 or 3 power supply lines while providing a balanced maximum power requirement for each line. In general, the backplane may be partitioned into any number of areas, such as e.g. into 6 areas, covering 1/4, 1/4, 1/12, 1/12, 1/12, 1/4 of the backplane, which would allow providing a maximum power requirement for connecting 1, 2, 3 or 4 power supply lines, each serving 1/1, 1/2, 1/3 or 1/4 of the overall maximum power draw supplied to the device, respectively. A further embodiment may comprise partitioning the backplane into 5 areas, covering 1/4, 1/4, 1/8, 1/8, 1/4 of the backplane, which would allow connecting 1, 2 or 4 power supply lines while keeping a balanced maximum power draw for each power supply line.

In the example embodiments shown in Fig. 3-5, the bridging elements 22 may e.g. be punched metal plates. However, alternative bridging elements may e.g. comprise cables, wire brackets, printed circuit boards, busbars, connectors or other electro-mechanical apparatus.

The various embodiments of the present method and device enable an efficient power supply system for a device, as the amount of power supply lines provided from a power source, such as e.g. a battery, may be adjusted according to the current upgrading and expansion state of the device. Thus, there is no need to provide a device with an oversized power supply system, if the power dissipation of the device in a specific configuration is fairly low. Further, the power supply system may be adapted quickly and easily by changing and/or adding bridging elements in a power supply interface, with no need to perform any changes on the backplane of the device.

It should be noted that the description and drawings merely illustrate the principles of the proposed methods and devices. It will thus be appreciated that those skilled in the art will be able to devise various arrangements that, although not explicitly described or shown herein, embody the principles of the claimed subject-matter and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments, as well as specific examples, are intended to encompass equivalents thereof.

Finally, it should be noted that any block diagrams herein represent conceptual views of illustrative circuitry embodying the principles of the claimed subject-matter. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A power supply arrangement, comprising:
a plurality of power supply areas;
a plurality of subsystem interfaces to connect subsystems, each subsystem interface coupled with one power supply area to supply power to the at least one subsystem connected with the subsystem interface; and
a power supply interface coupled with the plurality of power supply areas and
comprising a plurality of power supply terminals for being connected with one or more power supply lines, and configurable power distribution means for connecting the power supply terminals with the power supply areas,
wherein the number of power supply terminals is smaller than the number of power supply areas and the maximum powers that can be drawn by the subsystems connected to the individual power supply areas are arranged such that the maximum combined load for each connected power supply line is about the same, for all configurations of the power distribution means.

2. The power supply arrangement of claim 1, wherein at least one power distribution configuration of the power distribution means connects at least two power supply areas with one power supply terminal.

3. The power supply arrangement of claim 1, wherein all power distribution configurations of the power distribution means connect at least two power supply areas with one power supply terminal.

4. The power supply arrangement of any previous claim, wherein the power distribution means comprise a bridge for connecting at least one power supply terminal.

5. The power supply arrangement of claim 4, wherein the power supply terminals are spaced at regular distances and the bridge comprises at least one bridging element to connect neighboring power supply terminals.

6. The power supply arrangement of claim 4 or 5, wherein the power supply terminals are disposed in a two-dimensional grid where neighboring power supply terminals are displaced in both dimensions.

7. The power supply arrangement of claim 4 to 6, wherein the bridge comprises at least two substantially identical bridging elements.

8. The power supply arrangement of any previous claim, wherein the numbers of subsystem interfaces connected to each power supply area are selected so that the maximum combined load for each power supply line drawn by the subsystems connectable to the power supply line via the power distribution means and the subsystem interfaces is about the same, for all configurations of the power distribution means.

9. The power supply arrangement of any previous claim, wherein a plurality of power supply planes are provided on a backplane, wherein the plurality of power supply planes correspond to the plurality of power supply areas, the surface areas of the power supply planes having a predetermined ratio, the predetermined ratio depending on the number of power supply terminals.

10. The power supply arrangement of any previous claim, wherein the subsystem interfaces comprises a number of interface slots to receive printed circuit boards, the subsystems arranged on the printed circuit boards.

11. The power supply arrangement of any previous claim, wherein the power supply areas each support a predetermined portion of the total maximum power supplied by the power supply arrangement, wherein the maximum power supported by at least two power supply areas is half the maximum power supported by at least two other power supply areas.

12. The power supply arrangement of claim 11, wherein at least one configuration of the power distribution means connects two of the at least two power supply areas having half maximum power with a first common power supply terminal, and wherein at least one configuration of the power distribution means connects at least one power supply area having half maximum power and one power supply area having more than half maximum power with a second common power supply terminal.

13. The power supply arrangement of claim 11 or 12, wherein the predetermined portions of the total maximum power supported by the power supply areas are 1/3, 1/6, 1/6, and 1/3.

14. Telecommunications equipment comprising a power supply arrangement according to any of claims 1 to 13.

15. Method for power distribution in electronic equipment comprising
a plurality of power supply areas;
a plurality of subsystem interfaces for connecting subsystems, each subsystem interface coupled with one power supply area to supply power to the at least one subsystem when connected with the subsystem interface; and
a power supply interface coupled with the plurality of power supply areas and comprising a plurality of power supply terminals for being connected with one or more power supply lines, and configurable power distribution means for connecting the power supply terminals with the power supply areas,
the method comprising:
selecting the numbers of subsystem interfaces connected to each power supply area such that the maximum powers that can be drawn by the subsystems from the individual power supply areas are limited so that the resulting maximum combined load for each power supply line is about the same, for all configurations of the power distribution means.

## Amended claims

### Amended claims in accordance with Rule 137(2) EPC.

1. A power supply arrangement for a rack (10) in a telecommunication network equipment, comprising:
a plurality of power supply areas (12a, 12b, 12c, 12d) provided on a backplane (12);
a plurality of subsystem interfaces to connect subsystems, each subsystem interface coupled with one power supply area (12a, 12b, 12c, 12d) to supply power to at least one subsystem connected with the subsystem interface; and
a power supply interface (16) coupled with the plurality of power supply areas (12a, 12b, 12c, 12d) and comprising a plurality of power supply terminals for being connected with one or more power supply lines (20), and a configurable bridge for connecting the power supply terminals with the power supply areas (12a, 12b, 12c, 12d),
wherein the number of power supply terminals is smaller than the number of power supply areas (12a, 12b, 12c, 12d) and the maximum powers that can be drawn by the subsystems connected to the individual power supply areas (12a, 12b, 12c, 12d) are arranged such that the maximum combined load for each connected power supply line is about the same, for all configurations of the bridge,
wherein the power supply terminals are disposed in a two-dimensional grid where neighboring power supply terminals are arranged in both dimensions with a respective spacing between adjacent power supply terminals in a given direction being constant,
and the bridge comprises at least one bridging element (22) to connect neighboring power supply terminals.

2. The power supply arrangement of claim 1, wherein at least one power distribution configuration of the bridge connects at least two power supply areas (12a, 12b, 12c, 12d) with one power supply terminal.

3. The power supply arrangement of claim 1, wherein all power distribution configurations of the bridge connect at least two power supply areas (12a, 12b, 12c, 12d) with one power supply terminal.

4. The power supply arrangement of claim 1 to 3, wherein the bridge comprises at least two substantially identical bridging elements (22).

5. The power supply arrangement of any previous claim, wherein the numbers of subsystem interfaces connected to each power supply area (12a, 12b, 12c, 12d) are selected so that the maximum combined load for each power supply line (20) drawn by the subsystems connectable to the power supply line via the bridge and the subsystem interfaces is about the same, for all configurations of the bridge.

6. The power supply arrangement of any previous claim, wherein a plurality of power supply planes are provided on the backplane (12), wherein the plurality of power supply planes correspond to the plurality of power supply areas (12a, 12b, 12c, 12d), the surface areas of the power supply planes having a predetermined ratio, the predetermined ratio depending on the number of power supply terminals.

7. The power supply arrangement of any previous claim, wherein the subsystem interfaces comprises a number of interface slots to receive printed circuit boards (14), the subsystems arranged on the printed circuit boards (14).

8. The power supply arrangement of any previous claim, wherein the power supply areas (12a, 12b, 12c, 12d) each support a predetermined portion of the total maximum power supplied by the power supply arrangement, wherein the maximum power supported by at least two power supply areas (12b, 12c) is half the maximum power supported by at least two other power supply areas (12a, 12d).

9. The power supply arrangement of claim 8, wherein at least one configuration of the bridge connects two of the at least two power supply areas (12a, 12b, 12c, 12d) having half maximum power with a first common power supply terminal, and wherein at least one configuration of the bridge connects at least one power supply area (12a, 12b, 12c, 12d) having half maximum power and one power supply area (12a, 12b, 12c, 12d) having more than half maximum power with a second common power supply terminal.

10. The power supply arrangement of claim 8 or 9, wherein the predetermined portions of the total maximum power supported by the power supply areas (12a, 12b, 12c, 12d) are 1/3, 1/6, 1/6, and 1/3.

11. Telecommunications equipment comprising a power supply arrangement according to any of claims 1 to 10.

12. Method for power distribution in a rack (10) in a telecommunication network equipment comprising
a plurality of power supply areas provided on a backplane (12);
a plurality of subsystem interfaces for connecting subsystems, each subsystem interface coupled with one power supply area (12a, 12b, 12c, 12d) to supply power to at least one subsystem when connected with the subsystem interface; and
a power supply interface (16) coupled with the plurality of power supply areas (12a, 12b, 12c, 12d) and comprising a plurality of power supply terminals for being connected with one or more power supply lines (20), and a configurable bridge for connecting the power supply terminals with the power supply areas (12a, 12b, 12c, 12d),
the method comprising:
selecting the numbers of subsystem interfaces connected to each power supply area (12a, 12b, 12c, 12d) such that the maximum powers that can be drawn by the subsystems from the individual power supply areas (12a, 12b, 12c, 12d) are limited so that the resulting maximum combined load for each power supply line (20) is about the same, for all configurations of the bridge;
wherein the power supply terminals are disposed in a two-dimensional grid where neighboring power supply terminals are arranged in both dimensions with a respective spacing between adjacent power supply terminals in a given direction being constant,
and the bridge comprises at least one bridging element (22) to connect neighboring power supply terminals.
